# EUROPEAN PATENT SPECIFICATION

(11) **EP 2 925 103 B1**
(45) Date of publication and mention of the grant of the patent: **20.09.2017**
(21) Application number: 14162032.8
(22) Date of filing: 27.03.2014
(51) Int. Cl.: H05K 7/14

(54) **Cable management device**
Kabelführungsvorrichtung
Dispositif de gestion de câbles

(43) Date of publication of application: 30.09.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Weng, Cheng-Chieh, Kaohsiung City (TW); Wang, Chun-Chiang, Kaohsiung City (TW)
(74) Representative: Viering, Jentschura & Partner mbB Patent- und Rechtsanwälte

(56) References cited:
- WO-A1-2013/076855
- US-A1- 2012 312 761

## Description

### Field of the Invention

The present invention relates to a cable management device and more particularly to a cable management device applicable to a rack server.

### Background of the Invention

A rack server is a server mounted on a rack. Generally speaking, each of two corresponding lateral sides of a rack server is equipped with a slide rail assembly via which the server is mounted to a rack and which allows the server to be pulled out from the rack and pushed back into the rack in a similar way to a drawer.

Typically, a rack server has or is connected with a large number of electronic cables. While the server is pulled out from or pushed into a rack by means of a pair of slide rail assemblies, the cables may become untidy unless a device for managing or receiving the cables is used.

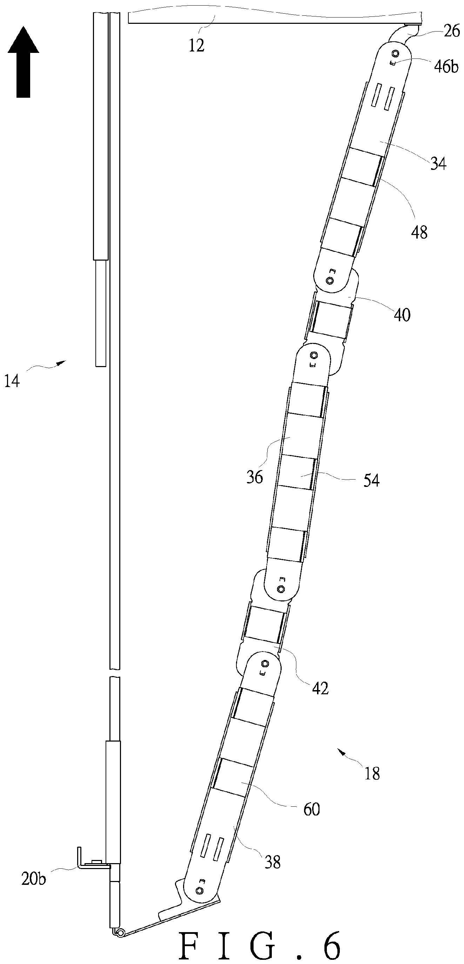

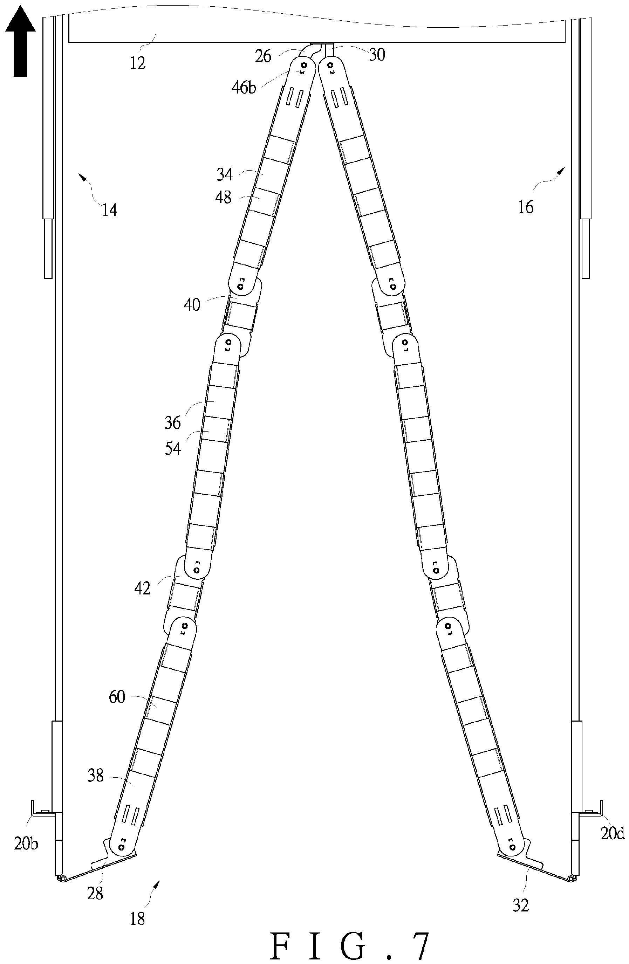

US Patent No. 8,379,410 discloses a reversible cable management arm system which essentially includes two connected cable support arms (138, 140) and a pivotable connector (150) located between the two cable support arms (138, 140). As shown in FIG. 6 and FIG. 7 of the '410 patent, one of the cable support arms (138) is connected with a second attachment member (152b), which is pivotally connected to a snap-on connector (160). The snap-on connector (160) is connected to the connector receiver (154) of a first slide member (134a). The other cable support arm (140) is connected with a first attachment member (152a), which is pivotally connected to another snap-on connector (158). This snap-on connector (158) is connected to the connector receiver (154) of a second slide member (134b). The cable support arm (138) and the second attachment member (152b) are interconnected by a tension member (172), and the cable support arm (140) and the first attachment member (152a) are interconnected by another tension member (170).

According to the disclosure of the '410 patent, cables (142) can remain tidy in the course where a server chassis (130) is pulled out from or pushed into a rack (132). In addition, the tension members (170, 172) respectively render the first attachment member (152a) and the second attachment member (152b) reversible in direction so that the folding direction of the cables (142) can be maintained.

However, the tension members (170, 172), which are springs, may undergo elastic fatigue or even become rusty after long-term use. In either case, the function of the cable management arm system as a whole will be compromised. Another cable management arm system comprising cable support arms connected with a pivotable connector is disclosed in document WO 2013/076855.

### Summary of the Invention

The present invention relates to a cable management device for use with a rack server.

According to one aspect of the present invention, a cable management device applicable to a rack server includes a first support arm, a second support arm, and a connecting member. The first support arm includes a front portion, a rear portion, and a first guiding portion located at the front portion of the first support arm. The second support arm includes a front portion, a rear portion, and a first guiding portion located at the front portion of the second support arm. The connecting member is movably connected between the first support arm and the second support arm. The connecting member includes a front guiding portion and a rear guiding portion. The first guiding portion of the first support arm can move along and relative to the front guiding portion of the connecting member, and the first guiding portion of the second support arm can move along and relative to the rear guiding portion of the connecting member. Each of the front guiding portion and the rear guiding portion of the connecting member is a curved groove or a protruding block and each of the first guiding portion of the first support arm and the first guiding portion of the second support arm is a protruding block or a curved groove movable only within the limited space defined by the corresponding one of the curved grooves or the protruding blocks. Each of the curved grooves defines a path corresponding to a 90-degree circular arc.

According to another aspect of the present invention, a cable management device applicable to a chassis is provided, wherein the chassis has a lateral side mounted to a rack by means of a slide rail assembly. The cable management device includes a first cable management arm which includes a first support arm, a second support arm, a first connecting member, a third support arm, and a second connecting member. The first support arm includes a front portion, a rear portion, a first guiding portion located at the front portion of the first support arm, and a second guiding portion located at the rear portion of the first support arm. The second support arm includes a front portion, a rear portion, a first guiding portion located at the front portion of the second support arm, and a second guiding portion located at the rear portion of the second support arm. The first connecting member is movably connected between the front portion of the first support arm and the front portion of the second support arm. The first connecting member includes a front guiding portion and a rear guiding portion. The third support arm includes a front portion, a rear portion, a first guiding portion located at the front portion of the third support arm, and a second guiding portion located at the rear portion of the third support arm. The second connecting member is movably connected between the rear portion of the second support arm and the rear portion of the third support arm. The second connecting member includes a front guiding portion and a rear guiding portion. The rear portion of the first support arm is movably connected to the chassis. The front portion of the third support arm is movably connected to one of the slide rail assembly and the rack. When the chassis is pulled out from the rack via the slide rail assembly, the first guiding portion of the first support arm is moved along and relative to the front guiding portion of the first connecting member, the first guiding portion of the second support arm is moved along and relative to the rear guiding portion of the first connecting member, the second guiding portion of the second support arm is moved along and relative to the front guiding portion of the second connecting member, and the second guiding portion of the third support arm is moved along and relative to the rear guiding portion of the second connecting member; as a result, the first support arm, the first connecting member, the second support arm, the second connecting member, and the third support arm are driven to an extended position.

Preferably, the cable management device further includes a first support member and a second support member. The first support member is connected between the chassis and the rear portion of the first support arm. The second support member is connected either between the slide rail assembly and the front portion of the third support arm or between the rack and the front portion of the third support arm.

Preferably, the front guiding portions and the rear guiding portions of the first connecting member and the second connecting member are curved grooves; and the first guiding portion of the first support arm, the first guiding portion and the second guiding portion of the second support arm, and the second guiding portion of the third support arm are protruding blocks respectively movable only within the limited spaces respectively defined by the curved grooves. Each of the curved grooves defines a path corresponding to a 90-degree circular arc.

According to yet another aspect of the present invention, a cable management device applicable to a chassis is provided, wherein the chassis is mounted to a rack by means of a pair of slide rail assemblies. The cable management device includes a first cable management arm and a second cable management arm. At least one of the first cable management arm and the second cable management arm at least includes a first support arm, a second support arm, a first connecting member, a third support arm, and a second connecting member. The first support arm includes a front portion, a rear portion, a first guiding portion located at the front portion of the first support arm, and a second guiding portion located at the rear portion of the first support arm. The second support arm includes a front portion, a rear portion, a first guiding portion located at the front portion of the second support arm, and a second guiding portion located at the rear portion of the second support arm. The first connecting member is movably connected between the front portion of the first support arm and the front portion of the second support arm. The first connecting member includes a front guiding portion and a rear guiding portion. The third support arm includes a front portion, a rear portion, a first guiding portion located at the front portion of the third support arm, and a second guiding portion located at the rear portion of the third support arm. The second connecting member is movably connected between the rear portion of the second support arm and the rear portion of the third support arm. The second connecting member includes a front guiding portion and a rear guiding portion. The rear portion of the first support arm is movably connected to the chassis. The front portion of the third support arm is movably connected to one of the slide rail assemblies or is movably connected to the rack. When the chassis is pulled out from the rack via the slide rail assemblies, the first guiding portion of the first support arm is moved along and relative to the front guiding portion of the first connecting member, the first guiding portion of the second support arm is moved along and relative to the rear guiding portion of the first connecting member, the second guiding portion of the second support arm is moved along and relative to the front guiding portion of the second connecting member, and the second guiding portion of the third support arm is moved along and relative to the rear guiding portion of the second connecting member; as a result, the first support arm, the first connecting member, the second support arm, the second connecting member, and the third support arm are driven to an extended position.

Preferably, the cable management device further includes a first support member, a second support member, a third support member, and a fourth support member. The first support member is movably connected between the chassis and the first cable management arm. The second support member is movably connected between the first cable management arm and one of the slide rail assemblies. The third support member is movably connected between the chassis and the second cable management arm. The fourth support member is movably connected between the second cable management arm and the other one of the slide rail assemblies. In addition, the first support member and the third support member are respectively connected to the chassis at positions adjacent to a rear middle part of the chassis.

### Brief Description of the Drawings

The invention as well as a preferred mode of use and the advantages thereof will be best understood by referring to the following detailed description of some illustrative embodiments in conjunction with the accompanying drawings, wherein:
FIG. 1 is a perspective view in which the cable management device in one embodiment of the present invention is applied to a rack server;
FIG. 2 is an exploded perspective view of one lateral half of the cable management device in FIG. 1;
FIG. 3 is a top view of one lateral half of the cable management device in FIG. 1;
FIG. 4 is a perspective view showing how support arms and a connecting member in the cable management device in FIG. 1 are mounted relative to one another;
FIG. 5 is a schematic drawing in which one lateral half of the cable management device in FIG. 1 has been extended to a predetermined position;
FIG. 6 is a schematic drawing in which one lateral half of the cable management device in FIG. 1 has been fully extended;
FIG. 7 is a schematic drawing in which both lateral halves of the cable management device in FIG. 1 have been fully extended; and
FIG. 8 is a perspective view in which the cable management device in another embodiment of the present invention is connected to a rack.

### Detailed Description of the Invention

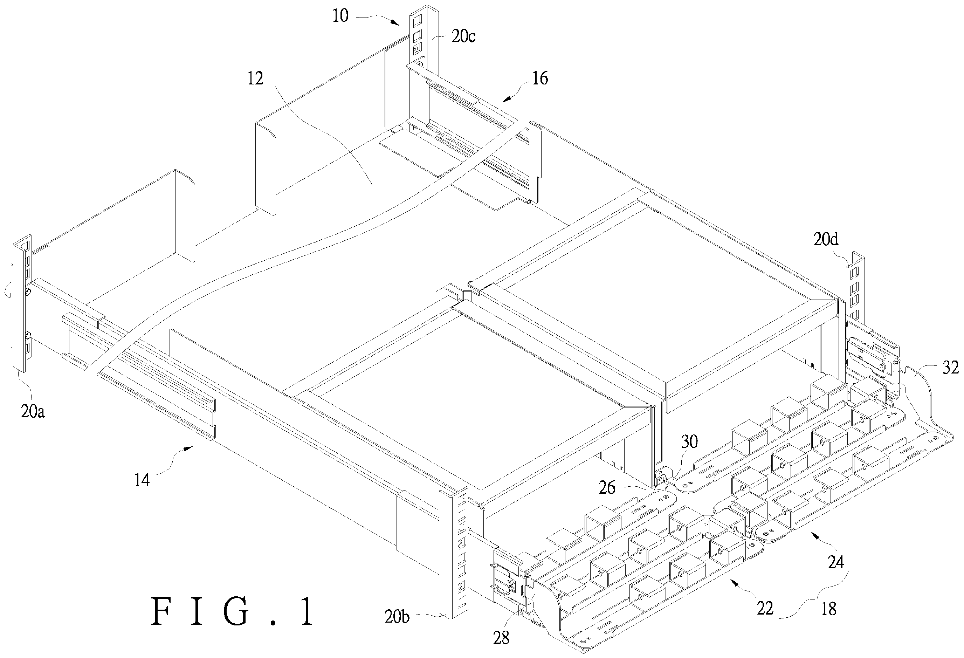

FIG. 1 shows a rack 10, a chassis 12, a first slide rail assembly 14, a second slide rail assembly 16, and a cable management device 18. The rack 10 includes a first post 20a, a second post 20b, a third post 20c, and a fourth post 20d. The first post 20a and the second post 20b correspond in position to the third post 20c and the fourth post 20d respectively. The chassis 12 has one lateral side mounted between the first post 20a and the second post 20b of the rack 10 by means of the first slide rail assembly 14. The opposite lateral side of the chassis 12 is mounted between the third post 20c and the fourth post 20d of the rack 10 by means of the second slide rail assembly 16. The cable management device 18 includes at least one cable management arm and preferably includes a first cable management arm 22 and a second cable management arm 24. The first cable management arm 22 and the second cable management arm 24 have substantially the same structural features. The first cable management arm 22 is movably connected between the chassis 12 and the first slide rail assembly 14. The second cable management arm 24 is movably connected between the chassis 12 and the second slide rail assembly 16.

In one preferred embodiment, a first support member 26 is movably connected between the chassis 12 and the first cable management arm 22, and a second support member 28 is movably connected between the first cable management arm 22 and the first slide rail assembly 14. Similarly, a third support member 30 is movably connected between the chassis 12 and the second cable management arm 24, and a fourth support member 32 is movably connected between the second cable management arm 24 and the second slide rail assembly 16. Preferably, the first support member 26 and the third support member 30 are respectively connected to the chassis 12 at positions adjacent to a rear middle part of the chassis 12.

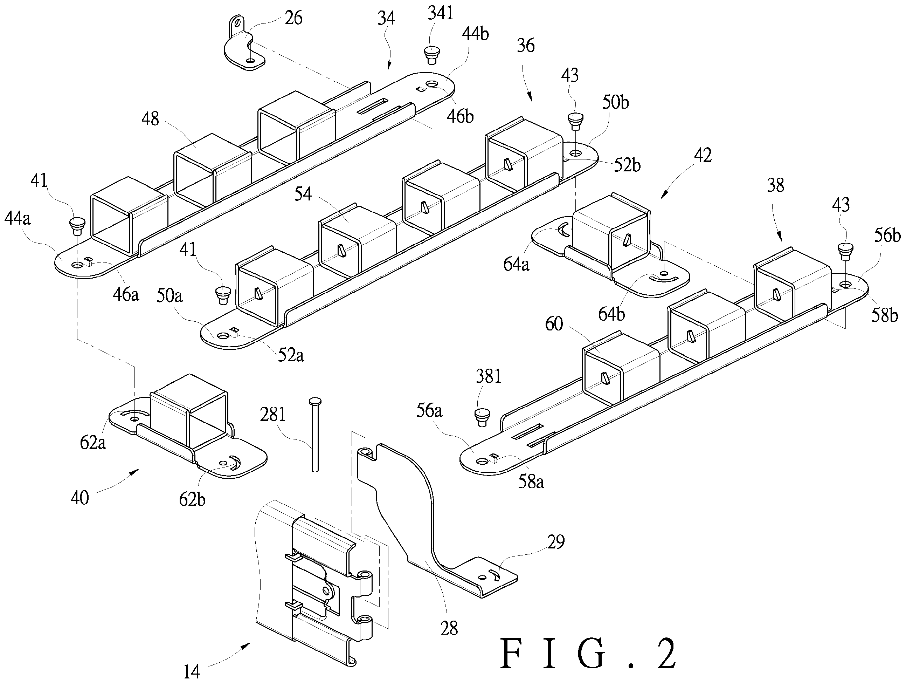

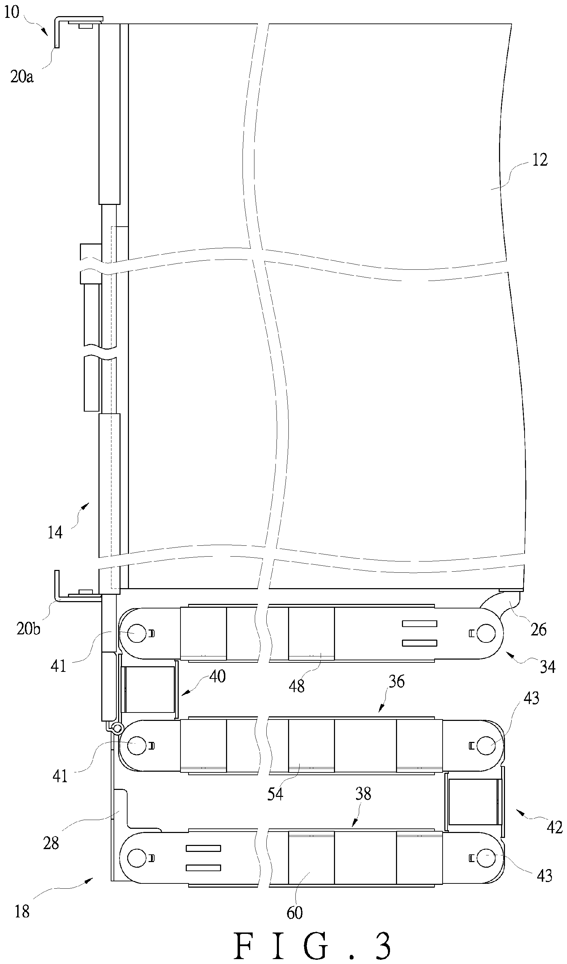

The first cable management arm is now described in more detail with reference to FIG. 2 and FIG. 3. The first cable management arm includes a first support arm 34, a second support arm 36, a third support arm 38, a first connecting member 40, and a second connecting member 42. The first connecting member 40 is movably connected between the first support arm 34 and the second support arm 36. The second connecting member 42 is movably connected between the second support arm 36 and the third support arm 38.

The first support arm 34 includes a front portion 44a, a rear portion 44b, a first guiding portion 46a located at the front portion 44a, a second guiding portion 46b located at the rear portion 44b, and a plurality of cable management elements 48 for cable management. The first guiding portion 46a and the second guiding portion 46b are configured in the same way.

The second support arm 36 includes a front portion 50a, a rear portion 50b, a first guiding portion 52a located at the front portion 50a, a second guiding portion 52b located at the rear portion 50b, and a plurality of cable management elements 54 for cable management. The first guiding portion 52a and the second guiding portion 52b are configured in the same way.

The third support arm 38 includes a front portion 56a, a rear portion 56b, a first guiding portion 58a located at the front portion 56a, a second guiding portion 58b located at the rear portion 56b, and a plurality of cable management elements 60 for cable management. The first guiding portion 58a and the second guiding portion 58b are configured in the same way.

The first connecting member 40 is movably connected between the first support arm 34 and the second support arm 36. The first connecting member 40 includes a front guiding portion 62a and a rear guiding portion 62b. Preferably, the first connecting member 40 is pivotally connected between the first support arm 34 and the second support arm 36 via a pair of first pivot elements 41.

The second connecting member 42 is movably connected between the second support arm 36 and the third support arm 38. The second connecting member 42 includes a front guiding portion 64a and a rear guiding portion 64b. Preferably, the second connecting member 42 is pivotally connected between the second support arm 36 and the third support arm 38 via a pair of second pivot elements 43.

More specifically, the first support arm 34 is pivotally connected to the first support member 26 via a third pivot element 341, wherein the first support member 26 is connected to the chassis 12. The third support arm 38 is pivotally connected to the second support member 28 via a fourth pivot element 381, and the second support member 28 is pivotally connected to the first slide rail assembly 14 via a fifth pivot element 281. Preferably, the second support member 28 has a curved groove 29 corresponding to the first guiding portion 58a of the third support arm 38, and the first guiding portion 58a is a protruding block movable only within the limited space defined by the curved groove 29.

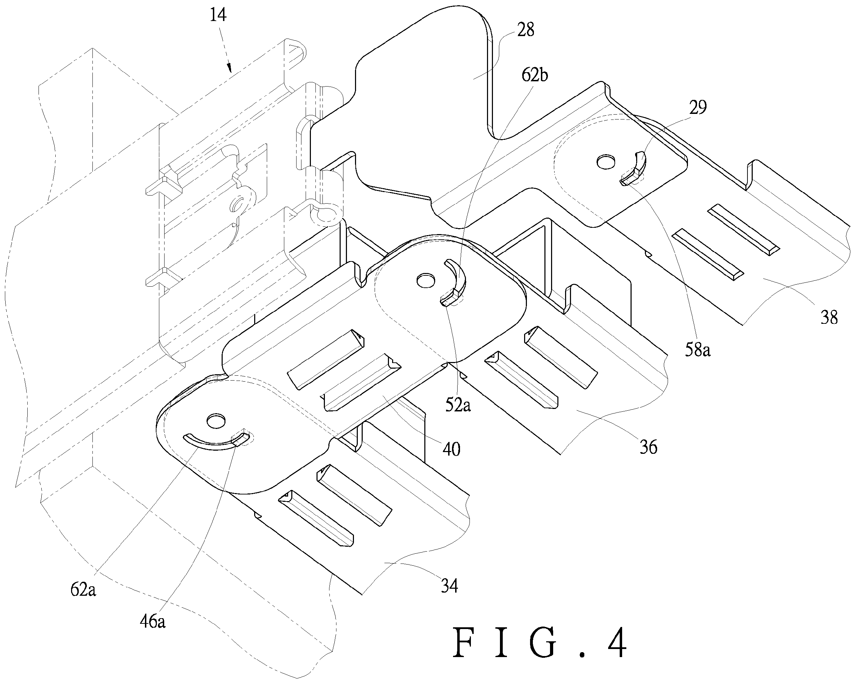

As shown in FIG. 4, the first guiding portion 46a of the first support arm 34 can move along and relative to the front guiding portion 62a of the first connecting member 40, the first guiding portion 52a of the second support arm 36 can move along and relative to the rear guiding portion 62b of the first connecting member 40, and the first guiding portion 58a of the third support arm 38 can move along and relative to the curved groove 29 of the second support member 28.

In one preferred embodiment, each of the front guiding portions 62a, 64a and the rear guiding portions 62b, 64b is a curved groove defining a path corresponding to a 90-degree circular arc, and each of the first guiding portions 46a, 52a and the second guiding portions 52b, 58b is a protruding block movable only within the limited space defined by the corresponding curved groove.

It should be noted that the front guiding portions 62a, 64a and the rear guiding portions 62b, 64b may be protruding blocks instead of the curved grooves described above, and the first guiding portions 46a, 52a and the second guiding portions 52b, 58b may be corresponding curved grooves instead of the protruding blocks described above.

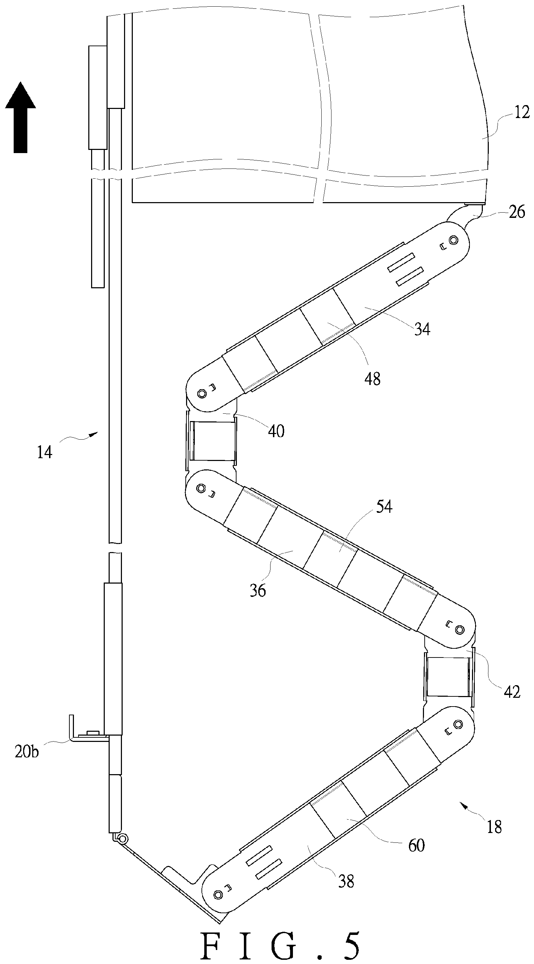

FIG. 5 and FIG. 6 show how the cable management device 18 operates. As shown in FIG. 5, when the chassis 12 is pulled out from the rack 10 by means of the slide rail assemblies (14, 16), the cable management device 18 is driven by the chassis 12 such that the first support arm 34, the first connecting member 40, the second support arm 36, the second connecting member 42, and the third support arm 38 are extended due to the curved groove-and-protruding block connections therebetween. The same curved groove-and-protruding block connections also provide the cable management device 18 with guiding and position-limiting functions, which help maintain the extending direction of the cables received in the cable management elements 48, 54, and 60. In FIG. 6, the cable management device 18 is in a fully extended state. FIG. 7 shows that both lateral halves of the cable management device 18 depicted in FIG. 1 are in the fully extended state.

When the chassis 12 is pushed back from outside of the rack 10 by means of the slide rail assemblies (14, 16), the movable connection between the first support arm 34 and the first support member 26 of the chassis 12 allows the cable management device 18 to be driven by the chassis 12. In other words, the first support arm 34, the first connecting member 40, the second support arm 36, the second connecting member 42, and the third support arm 38 will be folded due to the curved groove-and-protruding block connections therebetween. The same curved groove-and-protruding block connections also provide the cable management device 18 with guiding and position-limiting functions and help maintain the folding direction of the cables received in the cable management elements 48, 54, and 60. The cable management device 18 is thus in the fully folded state as shown in FIG. 3.

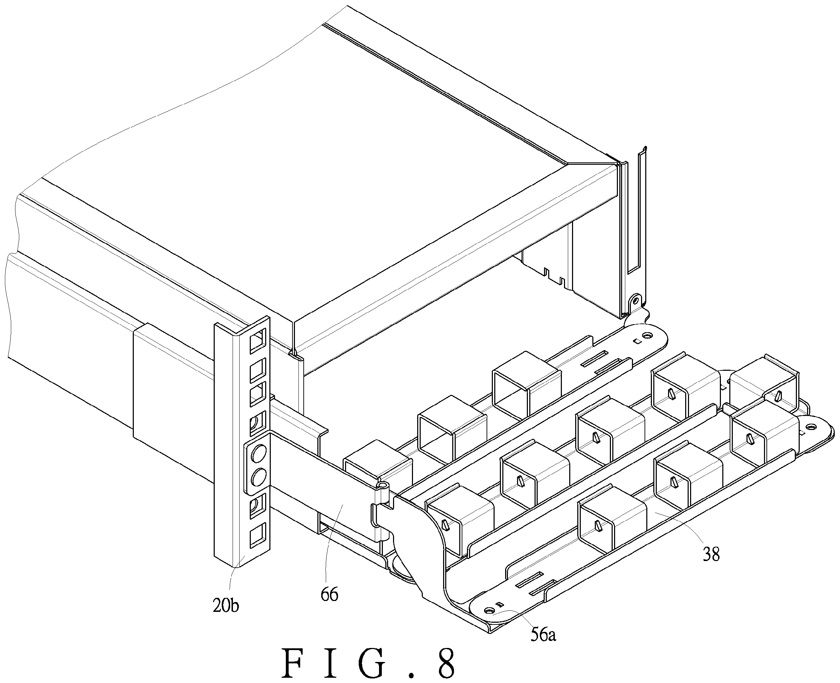

FIG. 8 shows another embodiment in which the front portion 56a of the third support arm 38 of the first cable management arm 22 is pivotally connected to the second post 20b of the rack via an extension member 66. Similarly, in the other lateral half of the cable management device 18 that is not shown in the drawing, the second cable management arm 24 is pivotally connected to the fourth post 20d via another extension member.

While the present invention has been disclosed through the foregoing preferred embodiments, it is understood that the embodiments are not intended to restrict the scope of the present invention. The scope of the present invention is defined only by the appended claims.

## Claims

1. A cable management device (18) applicable to a chassis (12) and comprising a first cable management arm (22), the first cable management arm (22) comprising:
a first support arm (34) comprising a front portion (44a), a rear portion (44b), and a first guiding portion (46a) located at the front portion (44a) of the first support arm (34);
a second support arm (36) comprising a front portion (50a), a rear portion (50b), and a first guiding portion (52a) located at the front portion (50a) of the second support arm (36); wherein the first cable management arm (22) further comprises:
a first connecting member (40) movably connected between the front portion (44a) of the first support arm (34) and the front portion (50a) of the second support arm (36); **characterised in that** the first connecting member (40) comprises a front guiding portion (62a) and a rear guiding portion (62b);
wherein the first guiding portion (46a) of the first support arm (34) is movable along and relative to the front guiding portion (62a) of the first connecting member (40), and the first guiding portion (52a) of the second support arm (36) is movable along and relative to the rear guiding portion (62b) of the first connecting member (40);
wherein each of the front guiding portion (62a) and the rear guiding portion (62b) of the first connecting member (40) is a curved groove or a protruding block, and each of the first guiding portion (46a) of the first support arm (34) and the first guiding portion (52a) of the second support arm (36) is a protruding block or a curved groove movable only within a limited space defined by a corresponding one of the curved grooves or the protruding blocks, and wherein each of the curved grooves defines a path corresponding to a 90-degree circular arc.

2. The cable management device (18) of claim 1, wherein the chassis (12) has a lateral side mounted to a rack (10) via a first slide rail assembly (14), the first support arm (34) further comprises a second guiding portion (46b) located at the rear portion (44b) of the first support arm (34), the second support arm (36) further comprises a second guiding portion (52b) located at the rear portion (50b) of the second support arm (36), and the first cable management arm (22) further comprises:
a third support arm (38) comprising a front portion (56a), a rear portion (56b), a first guiding portion (58a) located at the front portion (56a) of the third support arm (38), and a second guiding portion (58b) located at the rear portion (56b) of the third support arm (38); and
a second connecting member (42) movably connected between the rear portion (50b) of the second support arm (36) and the rear portion (56b) of the third support arm (38), the second connecting member (42) comprising a front guiding portion (64a) and a rear guiding portion (64b);
wherein the rear portion (44b) of the first support arm (34) is movably connected to the chassis (12); the front portion (56a) of the third support arm (38) is movably connected to one of the first slide rail assembly (14) and the rack (10); and when the chassis (12) is pulled out from the rack (10) via the first slide rail assembly (14), the first guiding portion (46a) of the first support arm (34) is moved along and relative to the front guiding portion (62a) of the first connecting member (40), the first guiding portion (52a) of the second support arm (36) is moved along and relative to the rear guiding portion (62b) of the first connecting member (40), the second guiding portion (52b) of the second support arm (36) is moved along and relative to the front guiding portion (64a) of the second connecting member (42), and the second guiding portion (58b) of the third support arm (38) is moved along and relative to the rear guiding portion (64b) of the second connecting member (42) such that the first support arm (34), the first connecting member (40), the second support arm (36), the second connecting member (42), and the third support arm (38) are driven to an extended position.

3. The cable management device (18) of claim 2, further comprising a first support member (26) and a second support member (28), wherein the first support member (26) is connected between the chassis (12) and the rear portion (44b) of the first support arm (34), and the second support member (28) is connected either between the first slide rail assembly (14) and the front portion (56a) of the third support arm (38) or between the rack (10) and the front portion (56a) of the third support arm (38).

4. The cable management device (18) of claim 3, wherein the second support member (28) has a curved groove (29) corresponding to the first guiding portion (58a) of the third support arm (38), and the first guiding portion (58a) of the third support arm (38) is a protruding block movable only within a limited space defined by the curved groove (29).

5. The cable management device (18) of claim 2, wherein the front guiding portion (64a) and the rear guiding portion (64b) of the second connecting member (42) each are a curved groove or a protruding block, and the second guiding portion (52b) of the second support arm (36) and the second guiding portion (58b) of the third support arm (38) each are a protruding block or a curved groove movable only within a limited space defined by a corresponding one of the curved grooves or the protruding blocks.

6. The cable management device (18) of claim 5, wherein each of the curved grooves defines a path corresponding to a 90-degree circular arc.

7. The cable management device (18) of claim 1, wherein the chassis (12) is mounted to a rack (10) via a pair of slide rail assemblies (14, 16), the cable management device (18) further comprises a second cable management arm (24), the first support arm (34) further comprises a second guiding portion (46b) located at the rear portion (44b) of the first support arm (34), the second support arm (36) further comprises a second guiding portion (52b) located at the rear portion (50b) of the second support arm (36), and the first cable management arm (22) further comprises:
a third support arm (38) comprising a front portion (56a), a rear portion (56b), a first guiding portion (58a) located at the front portion (56a) of the third support arm (38), and a second guiding portion (58b) located at the rear portion (56b) of the third support arm (38); and
a second connecting member (42) movably connected between the rear portion (50b) of the second support arm (36) and the rear portion (56b) of the third support arm (38), the second connecting member (42) comprising a front guiding portion (64a) and a rear guiding portion (64b);
wherein the rear portion (44b) of the first support arm (34) is movably connected to the chassis (12); the front portion (56a) of the third support arm (38) is movably connected to one of the slide rail assemblies (14, 16) or is movably connected to the rack (10); and when the chassis (12) is pulled out from the rack (10) via the slide rail assemblies (14, 16), the first guiding portion (46a) of the first support arm (34) is moved along and relative to the front guiding portion (62a) of the first connecting member (40), the first guiding portion (52a) of the second support arm (36) is moved along and relative to the rear guiding portion (62b) of the first connecting member (40), the second guiding portion (52b) of the second support arm (36) is moved along and relative to the front guiding portion (64a) of the second connecting member (42), and the second guiding portion (58b) of the third support arm (38) is moved along and relative to the rear guiding portion (64b) of the second connecting member (42) such that the first support arm (34), the first connecting member (40), the second support arm (36), the second connecting member (42), and the third support arm (38) are driven to an extended position.

8. The cable management device (18) of claim 7, further comprising a first support member (26), a second support member (28), a third support member (30), and a fourth support member (32), wherein the first support member (26) is movably connected between the chassis (12) and the first cable management arm (22), the second support member (28) is movably connected between the first cable management arm (22) and one of the slide rail assemblies (14, 16), the third support member (30) is movably connected between the chassis (12) and the second cable management arm (24), and the fourth support member (32) is movably connected between the second cable management arm (24) and the other one of the slide rail assemblies (14, 16).

9. The cable management device (18) of claim 8, wherein the first support member (26) and the third support member (30) are respectively connected to the chassis (12) at positions adjacent to a rear middle part of the chassis (12).

## Patentansprüche

1. Eine Kabelhaltevorrichtung (18) für ein Fahrwerk (12) und die einen ersten Kabelhaltearm (22) umfasst, wobei dieser erste Kabelhaltearm (22) die folgenden Komponenten umfasst:
einen ersten Tragarm (34), der einen vorderen Teil (44a) und einen hinteren Teil (44b) umfasst, während ein erster Führungsteil (46a) am vorderen Teil (44a) des ersten Tragarms (34) vorgesehen ist;
einen zweiten Tragarm (36), der einen vorderen Teil (50a) und einen hinteren Teil (50b) umfasst, während ein erster Führungsteil (52a) am vorderen Teil (50a) des zweiten Tragarms (36) vorgesehen ist; wobei der erste Kabelhaltearm (22) weiter die folgenden Komponenten umfasst:
einen ersten Verbindungsteil (40), der beweglich zwischen dem vorderen Teil (44a) des ersten Tragarms (34) und dem vorderen Teil (50a) des zweiten Tragarms (36) montiert ist; **dadurch gekennzeichnet, dass** der erste Verbindungsteil (40) einen vorderen Führungsteil (62a) und einen hinteren Führungsteil (62b) umfasst;
wobei der erste Führungsteil (46a) des ersten Tragarms (34) beweglich dem vorderen Führungsteil (62a) des ersten Verbindungsteils (40) entlang und relativ zu diesem montiert ist, während der erste Führungsteil (52a) des zweiten Tragarms (36) beweglich dem hinteren Führungsteil (62b) des ersten Verbindungsteils (40) entlang und relativ zu diesem montiert ist;
wobei jeder der vorderen Führungsteile (62a) und der hinteren Führungsteile (62b) des ersten Verbindungsteils (40) als eine Kurvennut oder einen vorstehenden Block ausgebildet sind, während jeder der ersten Führungsteile (46a) des ersten Tragarms (34) und der erste Führungsteil (52a) des zweiten Tragarms (36) als einen vorstehenden Block oder als eine Kurvennut ausgebildet sind, die nur innerhalb eines begrenzten Raums, der mit einem entsprechenden der Kurvennuten oder der vorstehenden Blöcke gebildet wird, beweglich sind, und wobei jede der Kurvennuten einen Weg in Übereinstimmung mit einem Kreisbogen von 90 Grad bilden.

2. Die Kabelhaltevorrichtung (18) nach Anspruch 1, wobei das Fahrwerk (12) eine laterale Seite aufweist, die mit einer Laufschienenmontage (14) an einem Gestell (10) montiert ist; der erste Tragarm (34) weiter einen zweiten Führungsteil (46b) umfasst, der am hinteren Teil (44b) des ersten Tragarms (34) vorgesehen ist; der zweite Tragarm (36) weiter einen zweiten Führungsteil (52b) umfasst, der am hinteren Teil (50b) des zweiten Tragarms (36) vorgesehen ist, wobei der erste Kabelhaltearm (22) weiter die folgenden Komponenten umfasst:
einen dritten Tragarm (38), der einen vorderen Teil (56a), einen hinteren Teil (56b) umfasst; ein erster Führungsteil (58a) am vorderen Teil (56a) des dritten Tragarms (38) und ein zweiter Führungsteil (58b) am hinteren Teil (56b) des dritten Tragarms (38) vorgesehen sind; und
einen zweiten Verbindungsteil (42), der beweglich zwischen dem hinteren Teil (50b) des zweiten Tragarms (36) und dem hinteren Teil (56b) des dritten Tragarm (38) montiert ist; der zweite Verbindungsteil (42) einen vorderen Führungsteil (64a) und einen hinteren Führungsteil (64b) umfasst;
wobei der hintere Teil (44b) des ersten Tragarms (34) beweglich am Fahrwerk (12) montiert ist; der vordere Teil (56a) des dritten Tragarms (38) beweglich an einem der ersten Laufschienenmontagen (14) und am Gestell (10) montiert ist; beim Herausziehen des Fahrwerks (12) aus dem Gestell (10) auf der ersten Laufschienenmontage (14) der erste Führungsteil (46a) des ersten Tragarms (34) am vorderen Führungsteil (62a) des ersten Verbindungsteils (40) entlang und relativ zu diesem bewegt wird; der erste Führungsteil (52a) des zweiten Tragarms (36) am hinteren Führungsteil (62b) des ersten Verbindungsteils (40) entlang und relativ zu diesem bewegt wird; der zweite Führungsteil (52b) des zweiten Tragarms (36) am vorderen Führungsteil (64a) des zweiten Verbindungsteils (42) entlang und relativ zu diesem bewegt wird und der zweite Führungsteil (58b) des dritten Tragarms (38) so am hinteren Führungsteil (64b) des zweiten Verbindungsteils (42) entlang und relativ bewegt wird, dass der erste Tragarm (34), der erste Verbindungsteil (40), der zweite Tragarm (36), der zweite Verbindungsteil (42) und der dritte Tragarm (38) in eine erweiterte Position angetrieben werden.

3. Die Kabelhaltevorrichtung (18) nach Anspruch 2, weiter umfassend ein erstes Stützglied (26) und ein zweites Stützglied (28), wobei das erste Stützglied (26) zwischen dem Fahrwerk (12) und dem hinteren Teil (44b) des ersten Tragarms (34) montiert ist, während das zweite Stützglied (28) entweder zwischen der ersten Laufschienenmontage (14) und dem vorderen Teil (56a) des dritten Tragarms (38) oder zwischen dem Gestell (10) und dem vorderen Teil (56a) des dritten Tragarms (38) montiert ist.

4. Die Kabelhaltevorrichtung (18) nach Anspruch 3, wobei das zweite Stützglied (28) in Übereinstimmung mit dem ersten Führungsteil (58a) des dritten Tragarms (38) eine Kurvennut (29) aufweist, während der erste Führungsteil (58a) des dritten Tragarms (38) als einen vorstehenden Block ausgebildet ist, der nur innerhalb eines begrenzten Raums, der mit der Kurvennut (29) gebildet ist, beweglich ist.

5. Die Kabelhaltevorrichtung (18) nach Anspruch 2, wobei der vordere Führungsteil (64a) und der hintere Führungsteil (64b) des zweiten Verbindungsteils (42) je als eine Kurvennut oder einen vorstehenden Block ausgebildet sind, während der zweite Führungsteil (52b) des zweiten Tragarms (36) und der zweite Führungsteil (58b) des dritten Tragarms (38) je als einen vorstehenden Block oder als eine Kurvennut ausgebildet sind, die nur innerhalb eines begrenzten Raums, der mit einer entsprechenden der Kurvennuten oder mit dem vorstehenden Block gebildet wird, beweglich sind.

6. Die Kabelhaltevorrichtung (18) nach Anspruch 5, wobei jede der Kurvennuten einen Weg bildet, der einem Kreisbogen von 90 Grad entspricht.

7. Die Kabelhaltevorrichtung (18) nach Anspruch 1, wobei das Fahrwerk (12) über ein Paar Laufschienenmontagen (14, 16) an einem Gestell (10) montiert ist; die Kabelhaltevorrichtung (18) weiter einen zweiten Kabelhaltearm (24) umfasst; der erste Tragarm (34) weiter einen zweiten Führungsteil (46b), der am hinteren Teil (44b) des ersten tragarms (34) vorgesehen ist, umfasst; der zweite Tragarm (36) weiter einen zweiten Führungsteil (52b), der am hinteren Teil (50b) des zweiten Tragarms (36) vorgesehen ist, umfasst und der erste Kabelhaltearm (22) weiter die folgenden Komponenten umfasst:
einen dritten Tragarm (38), umfassend einen vorderen Teil (56a), einen hinteren Teil (56b), einen ersten Führungsteil (58a) am vorderen Teil (56a) des dritten Tragarms (38) und einen zweiten Führungsteil (58b) am hinteren Teil (56b) des dritten Tragarms (38); und
einen zweiten Verbindungsteil (42), der beweglich zwischen dem hinteren Teil (50b) des zweiten Tragarms (36) und dem hinteren Teil (56b) des dritten Tragarms (38) montiert ist; der zweite Verbindungsteil (42) einen vorderen Führungsteil (64a) und einen hinteren Führungsteil (64b) umfasst;
wobei der hintere Teil (44b) des ersten Tragarms (34) beweglich am Fahrwerk (12) montiert ist; der vordere Teil (56a) des dritten Tragarms (38) beweglich an eine der Laufschienenmontagen (14, 16) oder beweglich am Gestell (10) montiert ist; beim Herausziehen des Fahrwerks (12) aus dem Gestell (10) auf der Laufschienenmontage (14, 16) der erste Führungsteil (46a) des ersten Tragarms (34) am vorderen Führungsteil (62a) des ersten Verbindungsteils (40) entlang und relativ zu diesem bewegt wird; der erste Führungsteil (52a) des zweiten Tragarms (36) am hinteren Führungsteil (62b) des ersten Verbindungsteils (40) entlang und relativ zu diesem bewegt wird; der zweite Führungsteil (52b) des zweiten Tragarms (36) am vorderen Führungsteil (64a) des zweiten Verbindungsteils (42) entlang und relativ zu diesem bewegt wird; der zweite Führungsteil (58b) des dritten Tragarms (38) so am hinteren Führungsteil (64b) des zweiten Verbindungsteils (42) entlang und relativ zu diesem bewegt wird, dass der erste Tragarm (34), der erste Verbindungsteil (40), der zweite Tragarm (36), der zweite Verbindungsteil (42) und der dritte Tragarm (38) in eine erweiterte Position angetrieben werden.

8. Die Kabelhaltevorrichtung (18) nach Anspruch 7, weiter umfassend ein erstes Stützglied (26), ein zweites Stützglied (28), ein drittes Stützglied (30) und ein viertes Stützglied (32), wobei das erste Stützglied (26) beweglich zwischen dem Fahrwerk (12) und dem ersten Kabelhaltearm (22) montiert ist; das zweite Stützglied (28) beweglich zwischen dem ersten Kabelhaltearm (22) und eine der Laufschienenmontagen (14, 16) montiert ist; das dritte Stützglied (30) beweglich zwischen dem Fahrwerk (12) und dem zweiten Kabelhaltearm (24) montiert ist; das vierte Stützglied (32) beweglich zwischen dem zweiten Kabelhaltearm (24) und eine der anderen Laufschienenmontagen (14, 16) montiert ist.

9. Die Kabelhaltevorrichtung (18) nach Anspruch 8, wobei das erste Stützglied (26) und das dritte Stützglied (30) je am Fahrwerk (12) in Positionen neben einem hinteren mittleren Teil des Fahrwerks (12) vorgesehen sind.

## Revendications

1. Dispositif de gestion des câbles (18) applicable à un châssis (12) et comprenant un premier bras de gestion des câbles (22), le premier bras de gestion des câbles (22) **caractérisé par le fait qu'**il comprend :
un premier bras de support (34) comprenant une partie avant (44a), une partie arrière (44b), et une première partie de guidage (46a) située sur la partie avant (44a) du premier bras de support (34) ;
un deuxième bras de support (36) comprenant une partie avant (50a), une partie arrière (50b), et une première partie de guidage (52a) située sur la partie avant (50a) du deuxième bras de support (36) ; le premier bras de gestion des câbles (22) comprend en outre :
un premier élément de raccordement (40) raccordé de manière mobile entre la partie avant (44a) du premier bras de support (34) et la partie avant (50a) du deuxième bras de support (36) ; **caractérisé en ce que** le premier élément de raccordement (40) comprend une partie avant de guidage (62a) et une partie arrière de guidage (62b) ;
la première partie de guidage (46a) du premier bras de support (34) est mobile le long et par rapport à la partie avant de guidage (62a) du premier élément de raccordement (40), et la première partie de guidage (52a) du deuxième bras de support (36) est mobile le long et par rapport à la partie arrière de guidage (62b) du premier élément de raccordement (40) ;
chaque partie avant de guidage (62a) et partie arrière de guidage (62b) du premier élément de raccordement (40) est une rainure incurvée ou un bloc saillant, et chaque première partie de guidage (46a) du premier bras de support (34) et première partie de guidage (52a) du deuxième bras de support (36) est un bloc saillant ou une rainure incurvée déplaçable seulement dans un espace limité défini par l'une des rainures incurvées ou l'un des blocs saillants correspondant, et chacune des rainures incurvées définit une trajectoire correspondant à un arc de cercle de 90° .

2. Dispositif de gestion des câbles (18) selon la revendication 1, **caractérisé par le fait que** le châssis (12) présente une paroi latérale montée sur un rack (10) via un premier ensemble de glissières (14), le premier bras de support (34) comprend en outre une seconde partie de guidage (46b) située sur la partie arrière (44b) du premier bras de support (34), le deuxième bras de support (36) comprend en outre une seconde partie de guidage (52b) située sur la partie arrière (50b) du deuxième bras de support (36), et le premier bras de gestion des câbles (22) comprend en outre :
un troisième bras de support (38) comprenant une partie avant (56a), une partie arrière (56b), une première partie de guidage (58a) située sur la partie avant (56a) du troisième bras de support (38), et une seconde partie de guidage (58b) située sur la partie arrière (56b) du troisième bras de support (38) ; et
un second élément de raccordement (42) raccordé de manière mobile entre la partie arrière (50b) du deuxième bras de support (36) et la partie arrière (56b) du troisième bras de support (38), le second élément de raccordement (42) comprenant une partie avant de guidage (64a) et une partie arrière de guidage (64b) ;
la partie arrière (44b) du premier bras de support (34) est raccordée de manière mobile au châssis (12) ; la partie avant (56a) du troisième bras de support (38) est raccordée de manière mobile au premier ensemble de glissières (14) et au rack (10) ; et lorsque le châssis (12) est retiré du rack (10) via le premier ensemble de glissières (14), la première partie de guidage (46a) du premier bras de support (34) est déplacée le long et par rapport à la partie avant de guidage (62a) du premier élément de raccordement (40), la première partie de guidage (52a) du deuxième bras de support (36) est déplacée le long et par rapport à la partie arrière de guidage (62b) du premier élément de raccordement (40), la seconde partie de guidage (52b) du deuxième bras de support (36) est déplacée le long et par rapport à la partie avant de guidage (64a) du second élément de raccordement (42), et la seconde partie de guidage (58b) du troisième bras de support (38) est déplacée le long et par rapport à la partie arrière de guidage (64b) du second élément de raccordement (42) de sorte que le premier bras de support (34), le premier élément de raccordement (40), le deuxième bras de support (36), le second élément de raccordement (42), et le troisième bras de support (38) sont amenés sur une position déployée.

3. Dispositif de gestion des câbles (18) selon la revendication 2, **caractérisé par le fait qu'**il comprend en outre un premier élément de support (26) et un deuxième élément de support (28), le premier élément de support (26) est raccordé entre le châssis (12) et la partie arrière (44b) du premier bras de support (34), et le deuxième élément de support (28) est raccordé soit entre le premier ensemble de glissières (14) et la partie avant (56a) du troisième bras de support (38) soit entre le rack (10) et la partie avant (56a) du troisième bras de support (38).

4. Dispositif de gestion des câbles (18) selon la revendication 3, **caractérisé par le fait que** le deuxième élément de support (28) présente une rainure incurvée (29) correspondant à la première partie de guidage (58a) du troisième bras de support (38), et la première partie de guidage (58a) du troisième bras de support (38) est un bloc saillant déplaçable seulement dans un espace limité défini par la rainure incurvée (29).

5. Dispositif de gestion des câbles (18) selon la revendication 2, **caractérisé par le fait que** la partie avant de guidage (64a) et la partie arrière de guidage (64b) du second élément de raccordement (42) sont chacune une rainure incurvée ou un bloc saillant, et la seconde partie de guidage (52b) du deuxième bras de support (36) et la seconde partie de guidage (58b) du troisième bras de support (38) sont chacune un bloc saillant ou une rainure incurvée déplaçable seulement dans un espace limité défini par l'une des rainures incurvées ou l'un des blocs saillants correspondant.

6. Dispositif de gestion des câbles (18) selon la revendication 5, **caractérisé par le fait que** chacune des rainures incurvées définit une trajectoire correspondant à un arc de cercle de 90° .

7. Dispositif de gestion des câbles (18) selon la revendication 1, **caractérisé par le fait que** le châssis (12) est monté sur un rack (10) via une paire d'ensembles de glissières (14, 16), le dispositif de gestion des câbles (18) comprend en outre un second bras de gestion des câbles (24), le premier bras de support (34) comprend en outre une seconde partie de guidage (46b) située sur la partie arrière (44b) du premier bras de support (34), le deuxième bras de support (36) comprend en outre une seconde partie de guidage (52b) située sur la partie arrière (50b) du deuxième bras de support (36), et le premier bras de gestion des câbles (22) comprend en outre :
un troisième bras de support (38) comprenant une partie avant (56a), une partie arrière (56b), une première partie de guidage (58a) située sur la partie avant (56a) du troisième bras de support (38), et une seconde partie de guidage (58b) située sur la partie arrière (56b) du troisième bras de support (38) ; et
un second élément de raccordement (42) raccordé de manière mobile entre la partie arrière (50b) du deuxième bras de support (36) et la partie arrière (56b) du troisième bras de support (38), le second élément de raccordement (42) comprenant une partie avant de guidage (64a) et une partie arrière de guidage (64b) ;
la partie arrière (44b) du premier bras de support (34) est raccordée de manière mobile au châssis (12) ; la partie avant (56a) du troisième bras de support (38) est raccordée de manière mobile à l'un des ensembles de glissières (14, 16) ou est raccordée de manière mobile au rack (10) ; et lorsque le châssis (12) est retiré du rack (10) via les ensembles de glissières (14, 16), la première partie de guidage (46a) du premier bras de support (34) est déplacée le long et par rapport à la partie avant de guidage (62a) du premier élément de raccordement (40), la première partie de guidage (52a) du deuxième bras de support (36) est déplacée le long et par rapport à la partie arrière de guidage (62b) du premier élément de raccordement (40), la seconde partie de guidage (52b) du deuxième bras de support (36) est déplacée le long et par rapport à la partie avant de guidage (64a) du second élément de raccordement (42), et la seconde partie de guidage (58b) du troisième bras de support (38) est déplacée le long et par rapport à la partie arrière de guidage (64b) du second élément de raccordement (42) de sorte que le premier bras de support (34), le premier élément de raccordement (40), le deuxième bras de support (36), le second élément de raccordement (42), et le troisième bras de support (38) sont amenés sur une position déployée.

8. Dispositif de gestion des câbles (18) selon la revendication 7, **caractérisé par le fait qu'**il comprend en outre un premier élément de support (26), un deuxième élément de support (28), un troisième élément de support (30), et un quatrième élément de support (32), le premier élément de support (26) est raccordé de manière mobile entre le châssis (12) et le premier bras de gestion des câbles (22), le deuxième élément de support (28) est raccordé de manière mobile entre le premier bras de gestion des câbles (22) et l'un des ensembles de glissières (14, 16), le troisième élément de support (30) est raccordé de manière mobile entre le châssis (12) et le second bras de gestion des câbles (24), et le quatrième élément de support (32) est raccordé de manière mobile entre le second bras de gestion des câbles (24) et l'autre ensemble de glissières (14, 16).

9. Dispositif de gestion des câbles (18) selon la revendication 8, **caractérisé par le fait que** le premier élément de support (26) et le troisième élément de support (30) sont respectivement raccordés au châssis (12) sur des positions adjacentes à une partie médiane arrière du châssis (12).
